# EUROPEAN PATENT APPLICATION

(11) **EP 2 017 307 A1**
(43) Date of publication of application: **21.01.2009**
(21) Application number: 07741903.4
(22) Date of filing: 18.04.2007
(51) Int. Cl.: C08L 101/00, C08L 51/00, H05K 3/28

(54) **THERMOSETTING RESIN COMPOSITION AND USE THEREOF**

(30) Priority: 28.04.2006 JP 2006126165
(71) Applicant: Showa Denko K.K., Tokyo 105-8518 (JP)
(72) Inventor: KIMURA, Kazuya, Kawasaki-shi, Kanagawa 210-0867 (JP); WADA, Tetsuo, Kawasaki-shi, Kanagawa 210-0867 (JP)
(74) Representative: Tack, Jens
(86) International application number: PCT/JP2007/058467
(87) International publication number: WO 2007/125806

(57) **Abstract**

Thermosetting resin compositions are excellent in balance among printability, tack properties, matting properties, electrical insulating properties and adhesion to objects. A thermosetting resin composition includes a thermosetting resin (A) and core-shell multilayer organic fine particles (B).

## Description

### TECHNICAL FIELD

The present invention relates to thermosetting resin compositions containing a thermosetting resin and core-shell multilayer organic fine particles as essential components. In more detail, the invention relates to thermosetting resin compositions that are excellent in balance among printability, tack properties, matting properties, electrical insulating properties and adhesion to objects, and are suitably used for applications including protective films and electrical insulating materials such as solder resists and interlayer dielectric films, encapsulating materials for IC and ULSI, and multilayer structures. The invention also relates to cured products of the compositions and uses of the cured products.

### BACKGROUND ART

Conventional thermosetting solder resist inks contain an inorganic filler to achieve improved printing properties that are required in fine pitch printing, as disclosed in JP-A-2003-113338 (Patent Document 1). However, the inorganic fillers generate impurities and reaggregates, and electrical insulating properties are lowered because of these defects.

Inorganic fillers are also used as means for improving surface stickiness (blocking) of cured films, in other words, as means for preventing tackiness in the case where the drying and curing time is shortened for enhanced productivity as described in JP-A-H06-107834 (Patent Document 2). However, the inorganic fillers reduce adhesion with objects.
Patent Document 1: JP-A-2003-113338
Patent Document 2: JP-A-H06-107834

### SUMMARY OF THE INVENTION

The present invention is aimed at solving the problems in the background art. Objects of the invention are to provide thermosetting resin compositions that are excellent in balance among printability, tack properties, matting properties, electrical insulating properties and adhesion to objects, and to provide uses of the compositions.

The present inventors diligently studied to solve the aforementioned problems, focusing on the finding that core-shell multilayer organic fine particles show good compatibility with thermosetting resins and do not reduce electrical insulating properties or adhesion with objects. As a result, the inventors have found that the conventional problems are solved according to thermosetting resin compositions containing a thermosetting resin and core-shell multilayer organic fine particles as essential components, thereby completing the present invention. The present invention relates to the following [1] to [14].

[1] A thermosetting resin composition comprising a thermosetting resin (A) and core-shell multilayer organic fine particles (B).

[2] The thermosetting resin composition described in [1], wherein the core-shell multilayer organic fine particles (B) have a spherical or substantially spherical shape.

[3] The thermosetting resin composition described in [1] or [2], wherein the core-shell multilayer organic fine particles (B) have an average particle diameter of 0.01 to 10 µm.

[4] The thermosetting resin composition described in any one of [1] to [3], wherein the thermosetting resin (A) comprises a urethane resin and a thermosetting component.

[5] The thermosetting resin composition described in [4], wherein the urethane resin is a carboxyl group-containing polyurethane.

[6] The thermosetting resin composition described in [5], wherein the carboxyl group-containing polyurethane is obtained by reacting a polyisocyanate compound (a), a polyol compound (b) (except carboxyl group-containing dihydroxy compounds (c)) and the carboxyl group-containing dihydroxy compound (c).

[7] The thermosetting resin composition described in [5], wherein the carboxyl group-containing polyurethane is obtained by reacting the polyisocyanate compound (a), the polyol compound (b) (except carboxyl group-containing dihydroxy compounds (c)), the carboxyl group-containing dihydroxy compound (c), and a monohydroxy compound (d) and/or a monoisocyanate compound (e).

[8] A solder resist ink comprising the thermosetting resin composition of any one of [1] to [7].

[9] A cured product produced by curing the thermosetting resin composition of any one of [1] to [7].

[10] An insulating protective film comprising the cured product of [9].

[11] A printed circuit board partially or entirely covered with the cured product of [9].

[12] A flexible printed circuit board partially or entirely covered with the cured product of [9].

[13] A chip on film partially or entirely covered with the cured product of [9].

[14] An electronic component including the cured product of [9].

### ADVANTAGES OF THE INVENTION

Conventional solder resist films have tackiness problems, low productivity due to clogging during filtration by reaggregated inorganic fillers, and deterioration in electrical insulating properties and adhesion with objects because of the inorganic fillers. According to the thermosetting resin compositions of the present invention, good printability, tack properties and matting properties are ensured while achieving excellent electrical insulating properties and adhesion to objects, which has been a trade off in the background art. According to the invention, high-performance solder resists and protective films are manufactured at low costs and with good productivity.

### BEST MODE FOR CARRYING OUT THE INVENTION

The present invention will be described below.

A thermosetting resin composition according to the present invention includes a thermosetting resin (A) and core-shell multilayer organic fine particles (B), and optionally contains a curing accelerator (C) and other additives. The components for the thermosetting resin compositions will be described below.

### (A) Thermosetting resins

Examples of the thermosetting resins (A) include combinations of a urethane resin and a thermosetting component, epoxy resins, phenolic resins, unsaturated polyester resins, alkyd resins, melamine resins and isocyanate resins. In view of flexibility and electrical insulating properties, combinations of a urethane resin and a thermosetting component are preferable, and combinations of a carboxyl group-containing polyurethane and a thermosetting component are more preferable.

In a preferred embodiment, the thermosetting resin composition contains a combination of a urethane resin and a thermosetting component, and core-shell multilayer organic fine particles (B). In a more preferred embodiment, the thermosetting resin composition contains a combination of a carboxyl group-containing polyurethane and a thermosetting component, and core-shell multilayer organic fine particles (B).

### <Carboxyl group-containing polyurethanes>

The carboxyl group-containing polyurethanes that are preferably used in the invention have two or more carboxyl groups in the molecule and have a urethane bond formed by reaction between a polyisocyanate compound and a polyol compound. The carboxyl group-containing polyurethanes may be obtained by reacting a polyisocyanate compound (a), a polyol compound (b) (except carboxyl group-containing dihydroxy compounds (c)) and a carboxyl group-containing dihydroxy compound (c). The reaction may involve a monohydroxy compound (d) and/or a monoisocyanate compound (e) as endcapping agents.

Examples of the polyisocyanate compounds (a) include diisocyanates such as 2,4-tolylene diisocyanate, 2,6-tolylene diisocyanate, isophorone diisocyanate, 1,6-hexamethylene diisocyanate, 1,3-trimethylene diisocyanate, 1,4-tetramethylene diisocyanate, 2,2,4-trimethylhexamethylene diisocyanate, 2,4,4-trimethylhexamethylene diisocyanate, 1,9-nonamethylene diisocyanate, 1,10-decamethylene diisocyanate, 1,4-cyclohexane diisocyanate, 2,2'-diethyl ether diisocyanate, diphenylmethane-4,4'-diisocyanate, o-xylene diisocyanate, m-xylene diisocyanate, p-xylene diisocyanate, methylene bis(cyclohexyl isocyanate), cyclohexane-1,3-dimethylene diisocyanate, cyclohexane-1,4-dimethylene diisocyanate, 1,5-naphthalene diisocyanate, p-phenylene diisocyanate, 3,3'-methyleneditolylene-4,4'-diisocyanate, 4,4'-diphenyl ether diisocyanate, tetrachlorophenylene diisocyanate, norbornane diisocyanate, hydrogenated 1, 3-xylylene diisocyanate and hydrogenated 1,4-xylylene diisocyanate. These compounds may be used singly, or two or more kinds may be used in combination.

Examples of the polyol compounds (b) (except carboxyl group-containing dihydroxy compounds (c)) include low-molecular weight diols, polycarbonate diols, polyether diols, polybutadienes that are hydroxylated at both ends, and polyester diols. These compounds may be used singly, or two or more kinds may be used in combination. In view of flexibility, electrical insulating properties and heat resistance, polycarbonate diols are preferred.

Examples of the carboxyl group-containing dihydroxy compounds (c) include 2,2-dimethylolpropionic acid, 2,2-dimethylolbutanoic acid, N,N-bishydroxyethylglycine and N,N-bishydroxyethylalanine. These compounds may be used singly, or two or more kinds may be used in combination. In view of solubility in solvents, 2,2-dimethylolpropionic acid and 2,2-dimethylolbutanoic acid are preferred.

Examples of the monohydroxy compounds (d) include 2-hydroxyethyl (meth)acrylate, hydroxypropyl (meth)acrylate, hydroxybutyl (meth)acrylate, cyclohexanedimethanol mono(meth)acrylate, adducts of these (meth)acrylates with caprolactones or alkylene oxides, glycerine di(meth)acrylate, trimethylol di (meth) acrylate, pentaerythritol tri (meth) acrylate, dipentaerythritol penta(meth)acrylate, ditrimethylolpropane tri(meth)acrylate, allyl alcohols, allyloxyethanol, glycolic acid, hydroxypivalic acid, methanol, ethanol, n-propanol, isopropanol, n-butanol, isobutanol, sec-butanol, t-butanol, amyl alcohol, hexyl alcohol and octyl alcohol. These compounds may be used singly, or two or more kinds may be used in combination.

Examples of the monoisocyanate compounds (e) include (meth)acryloyloxyethyl isocyanate, phenyl isocyanate, hexyl isocyanate and dodecyl isocyanate. These compounds may be used singly, or two or more kinds may be used in combination.

The polyisocyanate compounds (a), polyol compounds (b), carboxyl group-containing dihydroxy compounds (c), and monohydroxy compounds (d) and/or monoisocyanate compounds (e) may be used in a molar ratio wherein based on 1 mol of the polyisocyanate compounds (a), the number of moles of the polyol compounds (b) is 0.2 to 1.5, that of the carboxyl group-containing dihydroxy compounds (c) is 0.2 to 1.5, and that of the monohydroxy compounds (d) and/or monoisocyanate compounds (e) combined is 0.03 to 0.3, preferably wherein the number of moles of the polyol compounds (b) is 0.3 to 1.0, that of the carboxyl group-containing dihydroxy compounds (c) is 0.3 to 1.0, and that of the monohydroxy compounds (d) and/ormonoisocyanate compounds (e) combined is 0.05 to 0.2. If the amount of the polyol compounds (b) is less than the above range, the obtainable carboxyl group-containing polyurethane may have an insufficient molecular weight. If the amount exceeds the above range, residual polyol compounds (b) may cause stickiness. If the amount of the carboxyl group-containing dihydroxy compounds (c) is outside the above range, the obtainable carboxyl group-containing polyurethane may not have an appropriate acid value. If the amount of the monohydroxy compounds (d) and/or monoisocyanate compounds (e) is below the above range, the obtainable carboxyl group-containing polyurethane may not be sufficiently endcapped and may increase viscosity with time. If the amount exceeds the above range, residual monohydroxy compounds (d) and/or monoisocyanate compounds (e) may cause stickiness.

The carboxyl group-containing polyurethane preferably has a number-average molecular weight in the range of 500 to 100,000, and more preferably 8,000 to 30,000. The number-average molecular weight used herein is determined by gel permeation chromatography (GPC) relative to polystyrene standards. A number-average molecular weight of the carboxyl group-containing polyurethane that is below the above range may cause bad elongation, flexibility and strength of cured films. If the molecular weight exceeds the above range, cured films may be hard and have low flexibility.

The carboxyl group-containing polyurethane preferably has an acid value of 5 to 150 mg KOH/g, and more preferably 30 to 120 mg KOH/g. If the acid value is below this range, the reactivity with the thermosetting component is lowered and the heat resistance may be poor. If the acid value exceeds the above range, the obtainable cured films may have poor characteristics as resists such as alkali resistance and electrical insulating properties. The acid value of the resin is determined by titration with a 0.1 N alcoholic potassium hydroxide solution with phenolphthalein as an indicator in accordance with JIS K 2501.

### <Thermosetting components>

Examples of the thermosetting components suitably used in the invention include epoxy resins capable of reacting with the carboxyl group-containing polyurethanes. Such epoxy resins include epoxy compounds having two or more epoxy groups in the molecule, such as aliphatic glycidyl ethers, bisphenol A epoxy resins, hydrogenated bisphenol A epoxy resins, brominated bisphenol A epoxy resins, bisphenol F epoxy resins, novolac epoxy resins, phenol novolac epoxy resins, cresol novolac epoxy resins, N-glycidyl epoxy resins, bisphenol A novolac epoxy resins, chelated epoxy resins, glyoxal epoxy resins, amino group-containing epoxy resins, rubber-modified epoxy resins, dicyclopentadiene phenolic epoxy resins, silicone-modified epoxy resins and ε-caprolactone-modified epoxy resins. Halogen atoms such as chlorine and bromine, and atoms such as phosphorus may be introduced in the structures of these compounds to achieve flame retardance. The thermosetting components further include bisphenol S epoxy resins, diglycidyl phthalate resins, heterocyclic epoxy resins, bixylenol epoxy resins, biphenol epoxy resins and tetraglycidyl xylenoyl ethane resins.

The thermosetting resin composition may contain one or more thermosetting components. The amount of the thermosetting components is desirably such that the ratio of the epoxy equivalent of the thermosetting components to the carboxyl equivalent of the carboxyl group-containing polyurethanes is 1.0 to 3.0. If the epoxy to carboxyl equivalent ratio is below this range, the thermosetting resin composition may give cured films with insufficient electrical insulating properties. Any ratio more than that described above tends to result in greater shrinkage of cured films, and the cured films used as insulating protective films for flexible printed circuit boards (FPC) often show bad warpage.

### (B) Core-shell multilayer organic fine particles

Examples of the core-shell multilayer organic fine particles (B) include fine particles wherein a core composed of a rubber polymer is covered with a shell layer composed of a glass polymer, fine particles wherein a core composed of a glass polymer is covered with a shell layer composed of a rubber polymer, and three-layer structures wherein the two-layer structures above are covered with an outermost layer. Where necessary, the shell layer or the outermost layer may be modified so that functional groups such as carboxyl group, epoxy group and hydroxyl group will be introduced therein to provide compatibility and reactivity with the thermosetting resin. Examples of the cores include polybutadienes, acrylic polymers and polyisoprenes. Examples of the shell layers include alkyl acrylate-alkyl methacrylate copolymers, alkyl methacrylate-styrene copolymers and alkyl acrylate copolymers. In a preferred embodiment from the viewpoint of adhesion, the core is composed of a rubber polymer with a glass transition temperature of not more than room temperature such as polybutadiene, the shell layer is composed of an alkyl acrylate copolymer with a glass transition temperature of not less than 60°C, and the surface of the shell layer is modified with the carboxyl group. Unlike inorganic fillers, the core-shell multilayer organic fine particles described above do not cause defects such as air spaces on the particle interfaces for the following two reasons, and thus do not lower electrical insulating properties. The first reason is that the rubber polymer of the core relaxes strain by thermal cure shrinkage. Second, the organic fine particles have higher compatibility with the thermosetting component compared with inorganic fillers. The polymer of the shell layer provides high adhesion with objects compared with inorganic fillers, and the rubber polymer of the core relaxes external stress. Consequently, the adhesion with objects is ensured. Further, the fine particle form promises to provide increased viscosity and thixotropic properties of the composition, and printing properties are improved without using inorganic fillers. Furthermore, the organic fine particles have lower specific gravity than that of inorganic fillers and therefore they tend to be stable in the composition without settling and will provide unevenness on the surface of the film. Because the surface of the fine particles is a glass polymer, stickiness is not caused even when the fine particles provide unevenness on the film surface, and improved tack properties are promised. By using the core-shell multilayer organic fine particles as described above, the obtainable thermosetting resin compositions show excellent balance among printability, tack properties, matting properties, electrical insulating properties and adhesion to objects.

Examples of the core-shell multilayer organic fine particles (B) include STAPHYLOID IM-101, STAPHYLOID IM-203, STAPHYLOID IM-301, STAPHYLOID IM-401, STAPHYLOID IM-601, STAPHYLOID AC3355, STAPHYLOID AC3816, STAPHYLOID AC3832, STAPHYLOID AC4030, STAPHYLOID AC3364 (manufactured by GANZ CHEMICAL CO., LTD.), KUREHA BTA751, KUREHA BTA731, KUREHA PARALOID EXL2314, KUREHA PARALOID EXL2655 (manufactured by KUREHA CORPORATION), Albidur 2240, Albidur 5340, Albidur 5640 (manufactured by Hanse Chemie), PARALOID EXL2655, PARALOID EXL2605, PARALOID EXL2602, PARALOID EXL2311, PARALOID EXL2313, PARALOID EXL2314, PARALOID EXL2315, PARALOID BTA705, PARALOID BTA712, PARALOID BTA731, PARALOID BTA751, PARALOID KM357P, PARALOID KM336P, PARALOID HIA80 and PARALOID HIA28S (manufactured by Rohm and Hass Company).

The core-shell multilayer organic fine particles (B) preferably have a spherical or substantially spherical shape to avoid aggregation. Herein, the words substantially spherical mean that the longer diameter/shorter diameter ratio in an arbitrary elliptical cross section is from 1 to 10. The core-shell multilayer organic fine particles (B) preferably have an average particle diameter of 0.01 to 10 µm, and more preferably 0.1 to 5 µm. If the average particle diameter is smaller than the above range, matting properties and tack properties may not be sufficiently displayed. If the average particle diameter exceeds the above range, electrical insulating properties and adhesion with objects may be adversely affected. In the invention, the average particle diameter indicates a biaxial average particle diameter represented by (longer axis + shorter axis)/2. The average particle diameter may be determined by laser diffraction particle size distribution analysis.

The core-shell multilayer organic fine particles (B) may be of a single material or of two or more kinds of materials. The amount of the core-shell multilayer organic fine particles (B) is not particularly limited, but is preferably 1 to 40% by mass, and more preferably 5 to 30% by mass based on 100% by mass of the thermosetting resins (A). If the amount of the core-shell multilayer organic fine particles (B) is excessively small, printability, matting properties and tack properties tend to be lowered. An excessive amount thereof tends to cause nonuniform dispersion and reduce application properties.

### (C) Curing accelerators

The thermosetting resin composition may contain a curing accelerator (C) as required to facilitate curing reaction. The use of curing accelerators provides further improvements in adhesion, chemical resistance and heat resistance.

Examples of the curing accelerators (C) include curing agents and curing accelerators such as imidazole derivatives such as 2MZ, 2E4MZ, C11Z, C17Z, 2PZ, 1B2MZ, 2MZ-CN, 2E4MZ-CN, C11Z-CN, 2PZ-CN, 2PHZ-CN, 2MZ-CNS, 2E4MZ-CNS, 2PZ-CNS, 2MZ-AZINE, 2E4MZ-AZINE, C11Z-AZINE, 2MA-OK, 2P4MHZ, 2PHZ and 2P4BHZ manufactured by SHIKOKU CHEMICALS CORPORATION; guanamines such as acetoguanamine and benzoguanamine; polyamines such as diaminodiphenylmethane, m-phenylenediamine, m-xylenediamine, diaminodiphenylsulfone, dicyandiamide, urea, urea derivatives, melamine and polybasic hydrazide; organic acid salts and/or epoxy adducts of the above compounds; amine complexes of boron trifluoride; triazine derivatives such as ethyldiamino-S-triazine, 2,4-diamino-S-triazine and 2,4-diamino-6-xylyl-S-triazine; amines such as trimethylamine, triethanolamine, N,N-dimethyloctylamine, N-benzyldimethylamine, pyridine, N-methylmorpholine, hexa(N-methyl)melamine, 2,4,6-tris(dimethylaminophenol), tetramethylguanidine and m-aminophenol; polyphenols such as polyvinylphenols, polyvinylphenol bromides, phenol novolacs and alkylphenol novolacs; organic phosphines such as tributylphosphine, triphenylphosphine and tris-2-cyanoethylphosphine; phosphonium salts such as tri-n-butyl(2,5-dihydroxyphenyl)phosphonium bromide and hexadecyltributylphosphonium chloride; quaternary ammonium salts such as benzyltrimethylammonium chloride and phenyltributylammonium chloride; the polybasic acid anhydrides; cationic photopolymerization catalysts such as diphenyliodonium tetrafluoroborate, triphenylsulfonium hexafluoroantimonate, 2,4,6-triphenylthiopyrylium hexafluorophosphate, IRGACURE 261 manufactured by CIBA GEIGY, and OPTOMER SP-170 manufactured by ADEKA CORPORATION; styrene-maleic anhydride resin; and equimolar reaction product of phenyl isocyanate and dimethylamine, and equimolar reaction products of dimethylamine and organic polyisocyanates such as tolylene diisocyanate and isophorone diisocyanate.

The curing accelerators may be used singly, or two or more kinds may be used in combination. In the invention, the curing accelerators (C) are not indispensable but may be used when curing should be accelerated in an amount of not more than 25% by mass based on 100% by mass of the thermosetting component (A). If the amount exceeds 25% by mass, much components will be sublimated from the cured products, and the curing is excessively accelerated and the working life of the mixture is very limited.

### (D) Organic solvents

The thermosetting resin compositions according to the present invention may be obtained by dissolving or dispersing the thermosetting resins (A), the core-shell multilayer organic fine particles (B), and optionally the curing accelerators (C) and additives (E) described later by means of a mixer such as a disperser, a kneader, a three-roll mill or a bead mill. To facilitate the dissolution or dispersion of the thermosetting resins (A) and the core-shell multilayer organic fine particles (B), or to dilute the composition to an appropriate viscosity for application, an organic solvent (D) that is inert to the functional groups in the composition may be used.

Examples of the organic solvents (D) include toluene, xylene, ethylbenzene, nitrobenzene, cyclohexane, isophorone, diethylene glycol dimethyl ether, ethylene glycol diethyl ether, propylene glycol methyl ether acetate, propylene glycol ethyl ether acetate, dipropylene glycol methyl ether acetate, diethylene glycol ethyl ether acetate, diethylene glycol monobutyl ether acetate, 3-methoxy-3-methylbutyl acetate, methyl methoxypropionate, ethyl methoxypropionate, methyl ethoxypropionate, ethyl ethoxypropionate, ethyl acetate, n-butyl acetate, isoamyl acetate, ethyl lactate, acetone, methyl ethyl ketone, cyclohexanone, N,N-dimethylformamide, N,N-dimethylacetamide, N-methylpyrrolidone, γ-butyrolactone, dimethylsulfoxide, chloroform, petroleum naphtha and methylene chloride. The organic solvents may be used singly, or two or more kinds may be used in combination.

### (E) Additives

The thermosetting compositions may contain known additives including inorganic fillers such as barium sulfate, talc, calcium carbonate, alumina, glass powder, quartz powder and silica; fiber reinforcing materials such as glass fibers, carbon fibers and boron nitride fibers; coloring agents such as titanium oxide, zinc oxide, carbon black, iron black, organic pigments and organic dyes; antioxidants such as hindered phenol compounds, phosphorus compounds and hindered amine compounds; and ultraviolet absorbents such as benzotriazole compounds and benzophenone compounds. The compositions may contain ion exchangers, viscosity modifiers, flame retardants, anti-fungus agents, mildewproofing agents, anti-aging agents, antistatic agents, plasticizers, lubricants, foaming agents, anti-foaming agents and leveling agents depending on use. The amount of the additives (E) is not particularly limited, but is preferably not more than 30% by mass, and more preferably not more than 20% by mass based on 100% by mass of the thermosetting resin.

The thermosetting resin compositions of the invention include the aforementioned components. The thermosetting resin compositions may be used as solder resist inks. Cured products of the thermosetting resin compositions may be used as insulating protective films. The cured products are suitable for partially or entirely covering printed circuit boards, flexible printed circuit boards and chip on films (COF). The cured products may be used in electronic components.

Printed circuit boards, flexible printed circuit boards and chip on films (COF) that are partially or entirely covered according to the invention enable the manufacturing of electronic devices of high reliability without lowering productivity and yield.

### [Examples]

The present invention will be described based on examples below without limiting the scope of the invention.

### <Synthetic Example>

A reaction vessel equipped with a stirrer, a thermometer and a condenser was charged with 70.7 g of C-1065N (polycarbonate diol manufactured by KURARAY CO., LTD., molar ratio of material diols: 1,9-nonanediol:2-methyl-1,8-octanediol = 65:35, molecular weight: 991) as polyol compound, 13.5 g of 2,2-dimethylolbutanoic acid (manufactured by Nippon Kasei Chemical Company Limited) as carboxyl group-containing dihydroxy compound, and 128.9 g of diethylene glycol ethyl ether acetate (manufactured by DAICEL CHEMICAL INDUSTRIES, LTD.) as solvent. The materials were dissolved in the solvent at 90°C. The temperature of the reaction liquid was lowered to 70°C, and 42.4 g of methylene bis(4-cyclohexyl isocyanate) (DESMODULE W manufactured by Sumitomo Bayer Urethane Co., Ltd.) as polyisocyanate was added dropwise in 30 minutes with a dropping funnel. After the completion of the dropwise addition, reaction was carried out at 80°C for 1 hour, 90°C for 1 hour and 100°C for 2 hours. When peaks assigned to the isocyanate groups were substantially nil, 1.46 g of isobutanol (manufactured by Wako Pure Chemical Industries, Ltd.) was added dropwise, and reaction was performed at 105°C for 1.5 hours. The resultant carboxyl group-containing polyurethane had a number-average molecular weight of 6800 and an acid value in the solid of 39.9 mg KOH/g.

### [Example 1]

The polyurethane solution (solid concentration: 50% by mass) from Synthetic Example 1 was combined with, based on 100% by mass of the solid polyurethane: 37.5% by mass of an epoxy resin (EPIKOTE 828EL manufactured by JAPAN EPOXY RESIN CO., LTD.), an amount such that the equivalent ratio of the epoxy groups to the carboxyl groups in the polyurethane was 1.1; 4% by mass of melamine as curing accelerator; and 20% by mass of STAPHYLOID AC-3816 (manufactured by GANZ CHEMICAL CO., LTD., average particle diameter: 0.5 µm, low elastic modulus) as core-shell multilayer organic fine particles. The resultant composition was kneaded by being passed through a three-roll mill (RIII-1 RM-2 manufactured by Kodaira Seisakusho Co., Ltd.) three times. A solder resist ink was thus prepared.

### [Example 2]

A solder resist ink was prepared in the same manner as in Example 1, except that the core-shell multilayer organic fine particles were changed from STAPHYLOID AC-3816 in Example 1 to STAPHYLOID AC-3832 (manufactured by GANZ CHEMICAL CO., LTD., average particle diameter: 0.5 µm, modified with the carboxyl groups).

### [Example 3]

A solder resist ink was prepared in the same manner as in Example 1, except that the core-shell multilayer organic fine particles were changed from STAPHYLOID AC-3816 in Example 1 to STAPHYLOID AC-3364 (manufactured by GANZ CHEMICAL CO., LTD., average particle diameter: 0.1 µm, small-diameter particles with thixotropic properties).

### [Comparative Example 1]

A solder resist ink was prepared in the same manner as in Example 1, except that the core-shell multilayer organic fine particles were not used.

### [Comparative Example 2]

A solder resist ink was prepared in the same manner as in Example 1, except that the core-shell multilayer organic fine particles in Example 1 were replaced by acrylic fine particles (GANZPEARL PM-030 manufactured by GANZ CHEMICAL CO., LTD.).

### [Comparative Example 3]

A solder resist ink was prepared in the same manner as in Example 1, except that the core-shell multilayer organic fine particles in Example 1 were replaced by urethane fine particles (ARTPEARL C-400 manufactured by Negami Chemical Industrial Co., Ltd.).

### [Comparative Example 4]

A solder resist ink was prepared in the same manner as in Example 1, except that the core-shell multilayer organic fine particles in Example 1 were replaced by surface-treated barium sulfate (B-34 manufactured by SAKAI CHEMICAL INDUSTRY CO., LTD.).

### [Comparative Example 5]

A solder resist ink was prepared in the same manner as in Example 1, except that the core-shell multilayer organic fine particles in Example 1 were replaced by silicone rubber powder (KMP-594 manufactured by Shin-Etsu Chemical Co., Ltd.).

### [Comparative Example 6]

A solder resist ink was prepared in the same manner as in Example 1, except that the core-shell multilayer organic fine particles in Example 1 were replaced by silica fine particles (QUARTRON SP-03B manufactured by FUSO CHEMICAL CO., LTD.).

### [Comparative Example 7]

A solder resist ink was prepared in the same manner as in Example 1, except that the silicone powders in Example 1 were replaced by polypropylene fine particles (PP1362D manufactured by ITOH OIL CHEMICALS CO., LTD.).

### [Evaluation]

The solder resist inks from Examples 1-3 and Comparative Examples 1-7 were tested for printability, matting properties, tack properties, electrical insulating properties and adhesion with objects as described below. The results are shown in Table 1.

### <Printability>

The solder resist ink was applied to an IPC-C (comb-shaped pattern) of a commercially available substrate (IPC standard) by screen printing through a 100-mesh polyester screen. The ink was dried at 80°C for 30 minutes, and cured at 150°C for 1 hour. The cured ink on the fine wires was observed with a microscope, and the bleeding was evaluated by measuring the length to which the ink bled from the print end face. The evaluation was based on the following criteria.
AA: The bleeding was less than 50 µm in length.
BB: The bleeding was from 50 to 100 µm in length.
CC: The bleeding was more than 100 µm in length.

### <Matting properties>

The solder resist ink was applied to a substrate by screen printing through a 100-mesh polyester screen. The ink was dried at 80°C for 30 minutes, and cured at 150°C for 1 hour. The substrate used herein was a polyimide film 25 µm in thickness (Kapton™ 100EN manufactured by DU PONT-TORAY CO., LTD.). The cured film of the solder resist ink was visually observed and evaluated based on the following criteria.
AA: The film was matte.
BB: The film was slightly matte.
CC: The film had gloss.

### <Tack properties>

The solder resist ink was applied to a substrate by screen printing through a 100-mesh polyester screen. The ink was dried at 80°C for 30 minutes, and cured at 150°C for 1 hour. The substrate used herein was a polyimide film 25 µm in thickness (Kapton™ 100EN manufactured by DU PONT-TORAY CO., LTD.). The coated substrates were laminated through the resist-coated surfaces, and the tackiness was evaluated based on the following criteria.
AA: The resist-coated surfaces had no tackiness.
BB: The resist-coated surfaces had slight tackiness.
CC: The resist-coated surfaces had tackiness and attached together.

### <Electrical insulating properties>

The solder resist ink was applied to an IPC-C (comb-shaped pattern) of a commercially available substrate (IPC standard) by screen printing through a 100-mesh polyester screen. The ink was dried at 80°C for 30 minutes, and cured at 150°C for 1 hour. The coated substrate was exposed to 85°C and 85% RH, and a bias voltage of 100 V was applied to the substrate for 2000 hours. Electrical insulating properties were evaluated based on the following criteria.
AA: No migration and no decrease in insulation resistance occurred.
BB: Migration or decreased insulation resistance occurred after 1000-2000 hours.
CC: Migration or decreased insulation resistance occurred within 1000 hours.

### <Adhesion>

The solder resist ink was cured on a polyimide film (Kapton™ 300EN manufactured by DU PONT-TORAY CO., LTD.) on a copper substrate, and the adhesion was evaluated in accordance with JIS K 5600 (cross-cut test). A lattice pattern consisting of 100 squares at 1 mm intervals was created. A tape cut to approximately 75 mm in length was applied to the lattice pattern and was stripped at nearly 60° in 0.5 to 1.0 second. The tape was a product from NITTO CORPORATION. The evaluation was performed based on the following criteria.

AA: All the squares remained.
BB: 50 to less than 100 squares remained.
CC: Only less than 50 squares remained.

[Table 1]

**Table 1**

| | Fine particles | | | Properties | | | | |
|---|---|---|---|---|---|---|---|---|
| | Name | Details | Particle diameter (µm) | Printability | Matting properties | Tack properties | Electrical insulating properties | Adhesion |
| Ex. 1 | STAPHYLOID AC-3816 | Core-shell bilayer fine particles | 0.5 | BB | AA | AA | AA | BB |
| Ex. 2 | STAPHYLOID AC-3832 | Carboxyl-modified core-shell bilayer fine particles | 0.5 | BB | AA | AA | AA | AA |
| Ex. 3 | STAPHYLOID AC-3364 | Core-shell bilayer ultrafine particles | 0.1 | AA | AA | AA | AA | AA |
| Comp. Ex. 1 | - | - | - | CC | CC | CC | AA | AA |
| Comp. Ex. 2 | GANZPEARL PM-030 | Acrylic fine particles | 0.3 | AA | AA | CC | AA | AA |
| Comp. Ex. 3 | ARTPEARL C-400 | Urethane fine particles | 5.5 | BB | AA | AA | CC | AA |
| Comp. Ex. 4 | B-34 | Surface treated barium sulfate | 0.3 | BB | CC | CC | BB | CC |
| Comp. Ex. 5 | KMP-594 | Silicone rubber fine particles | 5.0 | CC | AA | AA | AA | BB |
| Comp. Ex. 6 | QUARTRON SP-03B | Silica fine particles | 0.3 | BB | BB | CC | BB | CC |
| Comp. Ex. 7 | pp1362D | Polypropylene fine particles | 3.0 | CC | AA | CC | AA | BB |

## Claims

1. A thermosetting resin composition comprising a thermosetting resin (A) and core-shell multilayer organic fine particles (B).

2. The thermosetting resin composition according to claim 1, wherein the core-shell multilayer organic fine particles (B) have a spherical or substantially spherical shape.

3. The thermosetting resin composition according to claim 1 or 2, wherein the core-shell multilayer organic fine particles (B) have an average particle diameter of 0.01 to 10 µm.

4. The thermosetting resin composition according to any one of claims 1 to 3, wherein the thermosetting resin (A) comprises a urethane resin and a thermosetting component.

5. The thermosetting resin composition according to claim 4, wherein the urethane resin is a carboxyl group-containing polyurethane.

6. The thermosetting resin composition according to claim 5, wherein the carboxyl group-containing polyurethane is obtained by reacting a polyisocyanate compound (a), a polyol compound (b) (except carboxyl group-containing dihydroxy compounds (c)) and the carboxyl group-containing dihydroxy compound (c).

7. The thermosetting resin composition according to claim 5, wherein the carboxyl group-containing polyurethane is obtained by reacting the polyisocyanate compound (a), the polyol compound (b) (except carboxyl group-containing dihydroxy compounds (c)), the carboxyl group-containing dihydroxy compound (c), and a monohydroxy compound (d) and/or a monoisocyanate compound (e).

8. A solder resist ink comprising the thermosetting resin composition of any one of claims 1 to 7.

9. A cured product produced by curing the thermosetting resin composition of any one of claims 1 to 7.

10. An insulating protective film comprising the cured product of claim 9.

11. A printed circuit board partially or entirely covered with the cured product of claim 9.

12. A flexible printed circuit board partially or entirely covered with the cured product of claim 9.

13. A chip on film partially or entirely covered with the cured product of claim 9.

14. An electronic component including the cured product of claim 9.
